# EUROPÄISCHE PATENTSCHRIFT

(11) **EP 2 553 811 B1**
(45) Veröffentlichungstag und Bekanntmachung des Hinweises auf die Patenterteilung: **22.01.2014**
(21) Anmeldenummer: 11707645.5
(22) Anmeldetag: 03.03.2011
(51) Int. Cl.: H03K 17/082

(54) **DETEKTIONSSCHALTUNG UND VERFAHREN ZUM BETREIBEN EINER DETEKTIONSSCHALTUNG**
DETECTION CIRCUIT AND METHOD FOR OPERATING A DETECTION CIRCUIT
CIRCUIT DE DÉTECTION ET PROCÉDÉ POUR FAIRE FONCTIONNER UN CIRCUIT DE DÉTECTION

(30) Priorität: 30.03.2010 DE 102010013322
(43) Veröffentlichungstag der Anmeldung: 06.02.2013
(73) Patentinhaber: ams AG, 8141 Unterpremstätten (AT)
(72) Erfinder: NIEDERBERGER, Mark, CH-8840 Einsiedeln (CH); LEONARDO, Vincenzo, CH-8820 Wädenswil (CH)
(74) Vertreter: Epping - Hermann - Fischer
(86) Internationale Anmeldenummer: PCT/EP2011/053197
(87) Internationale Veröffentlichungsnummer: WO 2011/120756

(56) Entgegenhaltungen:
- US-A- 5 898 554

## Beschreibung

In vielen industriellen Anwendungen von Sensoren werden Schalter verwendet, die eine Ausgangsklemme gegen eine Versorgungsspannung bzw. ein Bezugspotential schalten. Diese Low-Side- (NPN) oder High-Side-Switches (PNP) stellen leistungselektronische integrierte Schaltkreise mit zusätzlichen Schutz- und Überwachungsfunktionen dar. Dabei schaltet ein High-Side-Switch eine positive Versorgungsspannung, ein Low-Side-Switch eine negative Versorgungsspannung. Als eine typische Funktion solcher Schalter wird beispielsweise ein Sensorzustand signalisiert. So ist der Schalter geschlossen, wenn ein Sensor etwas detektiert und offen, falls der Sensor nicht detektiert. Auch der umgekehrte Fall ist möglich. Ausgangsseitig sind sowohl Low Side- wie High-Side-Switches in der Lage, einige 100 mA zu treiben und weisen dabei einen Ausgangswiderstand von kleiner als 10 Ω auf.

Eine weitere Funktion der Schalter umfasst den Schutz eines Sensors vor Kurzschlüssen. Wird beispielsweise durch eine geeignete Kurzschlussdetektionsschaltung ein Kurzschluss detektiert, so veranlasst ein Low Side- oder High Side-Schalter ein Ausschalten einer Last für ein bestimmtes Zeitintervall (etwa 100 ms). Nach dieser Abschaltzeit erfolgt eine weitere Detektion eines Kurzschlusses und gegebenenfalls wieder ein Ausschalten der Last für ein weiteres Zeitintervall. In der Regel sind diese Abschaltzeiten programmierbar und können beispielsweise 100 ms, 200 ms oder jeden anderen geeigneten Wert darstellen.

Von besonderer Wichtigkeit ist jedoch, dass ein Kurzschluss mit einer hohen Genauigkeit festgestellt werden muss. Dies dient dem Schutz der Sensoren. Der Kurzschlussschutz dient darüber hinaus auch dem Schutz einer kompletten Anlage, in der der Sensor eingebaut ist. Andererseits soll aber auch gewährleistet werden, dass ein Sensor auch dann noch funktioniert, wenn ungünstige, aber harmlose Umgebungssignale auftreten. Typische ungünstige Umgebungssignale werden beispielsweise durch EMC-Konditionen (EMC: Electromagnetic Compatibility) auftreten und sich in Form von Pulsen und Signalspitzen äußern.

Typische Detektionsschaltkreise überwachen eine Spannung an einem Ausgangsknoten, beispielsweise dem Drainanschluss eines CMOS-Transistors (CMOS: Complementary Metal Oxide Semiconductor). Ein Kurzschluss wird durch den Detektionsschaltkreis angezeigt, wenn die Spannung am Knoten zu hoch ist und damit beispielsweise einen vorgegebenen Vergleichswert überschreitet. Ein entsprechender Schalter, wie ein Transistor, wird dann den Schalter öffnen oder schließen und so beispielsweise eine Last von einer Versorgungsspannung abtrennen. Nachteilig ist jedoch, dass typische Schalter wie Transistoren einen parasitären Diodeneffekt aufweisen. Beispielsweise EMC-Signale bzw. -Spannungen haben dadurch einen deutlich asymmetrischen Signalverlauf und weisen einen negativen oder positiven Ausschlag auf. Diese Signale können wiederum ausreichen, um ein Kurzschlussereignis anzuzeigen, auch wenn dieses gar nicht vorliegt.

Die Patentschrift US 5,898,554 zeigt eine Treiberschaltung für einen Halbleiter-Leistungsschalter. Dieser verfügt über einen Steueranschluss und einen schaltbaren Strompfad und umfasst zudem Mittel, die mit dem Steueranschluss verbunden sind, um eine Spannung zum Steueranschluss bereitzustellen. Ferner sind Mittel vorgesehen, die mit dem schaltbaren Strompfad verbunden sind, um eine Kurzschlussbedingung zu erkennen, und Mittel, die auf eine erkannte Kurzschlussbedingung ansprechen, um die Spannung auf dem Steueranschluss herunterzufahren. Dabei sind die auf eine erkannte Kurzschlussbedingung ansprechende Mittel zum linearen Herunterfahren der Spannung auf dem Steueranschluss und zum Verhindern einer grossen Spannungsspitze über den schaltbaren Strompfad ausgelegt.

Aufgabe der Erfindung ist es daher, eine Detektionsschaltung vorzusehen, die einen Kurzschluss mit verbesserter Genauigkeit detektieren kann.

Diese Aufgabe wird mit den Gegenständen der unabhängigen Patentansprüche gelöst. Ausgestaltungsformen und Weiterbildungen sind Gegenstand der Unteransprüche.

Erfindungsgemäß umfasst eine Detektionsschaltung einen Detektionspfad und einen Steuerungspfad. Der Detektionspfad umfasst einen Signalbegrenzer mit einem Signaleingang, der mit einem Detektionsknoten verbunden ist. Ferner weist der Detektionspfad ein Filter auf, das mit einem Signalausgang des Signalbegrenzers gekoppelt ist. Ein Kurzschlussdetektor weist einen ersten und zweiten Detektoreingang sowie einen Detektorausgang auf. Dabei ist der erste Detektoreingang mit dem Filter gekoppelt.

Der Steuerungspfad umfasst einen Kontrollschaltkreis zum Steuern eines Schalters. Mittels eines Kontrolleingangs ist der Kontrollschaltkreis mit dem Detektorausgang und dem Filter gekoppelt. Ein Kontrollausgang des Kontrollschaltkreises ist mit dem Schalter verbunden. Der Schalter wiederum ist mit dem Detektionsknoten und einem Versorgungsknoten gekoppelt.

Am Detektionsknoten ist beispielsweise ein Sensor anschließbar. Tritt beispielsweise ein Kurzschluss an diesem Sensor auf, der den Sensor zerstören könnte, liegt am Detektionsknoten ein für dieses Ereignis charakteristisches Signal an. Dieses Signal wird in der Folge zunächst dem Signalbegrenzer zugeführt. Der Signalbegrenzer ist dafür eingerichtet, die Signalamplitude des Signals auf ein Messintervall zu begrenzen, welches mittels eines Schwellenwertes einstellbar ist, wobei der Schwellenwert die Mitte des Messintervalls bestimmt. Auf diese Weise generiert der Signalbegrenzer ein Zwischensignal, das dem Filter zugeführt wird. Das Filter wiederum filtert das Zwischensignal zu einem gefilterten Zwi schensignal. Das so vorverarbeitete gefilterte Zwischensignal liegt dann am Kurzschlussdetektor beziehungsweise dem ersten Detektoreingang an. Der

Kurzschlussdetektor ist dazu eingerichtet, aus dem gefilterten Zwischensignal ein Kurzschlussereignis zu erkennen und entsprechend ein Kontrollsignal zu generieren, das über den Detektorausgang dem Kontrollschaltkreis beziehungsweise dem Kontrolleingang zugeführt wird.

In Abhängigkeit des Kontrollsignals schaltet der Kontrollschaltkreis den Schalter. Hat der Kurzschlussdetektor einen Kurzschluss detektiert, so veranlasst das Kontrollsignal, dass der Schalter schließt oder öffnet und eine angeschlossene Last von einer Versorgungsspannung getrennt wird.

Vorteilhafterweise lässt sich durch den Signalbegrenzer ein Signal am Detektionsknoten geeignet begrenzen. Liegen beispielsweise am Detektionsknoten ungewollte, aber für einen Sensor ungefährliche Signale an, lässt sich dies durch den Signalbegrenzer berücksichtigen. Größere und zeitlich begrenzte Ausschläge infolge von Pulsen und Signalspitzen führen auf diese Weise nicht zur Detektion eines Kurzschlusses. Dabei kann je nach verwendetem Schaltertyp, beispielsweise einem Low- oder High Side-Schalter, die Signalamplitude nach oben oder unten begrenzen. Mit Hilfe des nachgeschalteten Filters lassen sich weiterhin charakteristische Parameter für die Detektionsschaltung einstellen. So wird beispielsweise gewährleistet, dass für typischerweise auftretende Signale am Detektionsknoten eine ausreichende Begrenzung realisiert werden kann. Durch die Kombination des Signalbegrenzers mit dem nachgeschalteten Filter ist es somit möglich, eine verbesserte Kurzschlussdetektion zu realisieren.

Die Detektionsschaltung dient dem Kurzschlussschutz. Im Falle eines Kurzschlusses wird vermieden, dass der Schalter beispielsweise durch thermische Überlastung zerstört wird. Darüber hinaus bietet die Detektionsschaltung Schutz für eine gesamte Anlage, in der der Sensor zusammen mit dem Schalter verbaut ist.

Wird in der folgenden Beschreibung direkt oder indirekt auf die Verwendung eines Schalters mit einem asymmetrischen Schaltverhalten eingegangen, so ist dies nicht als Beschränkung, sondern als eine mögliche Ausführungsform zu verstehen. Werden beispielsweise Low Side- oder High Side-Schalter verwendet, werden diese in dem Sinne asymmetrisch schalten, dass nur positive oder negative Betriebsspannungen geschaltet werden. Beide Fälle lassen sich ohne Beschränkung der Erfindung entsprechend implementieren. Die Schalter (High Side oder Low Side) sind typischerweise Teil des Sensors. An geeigneten Ausgänge wird signalisiert, ob der Sensor etwas detektiert hat oder nicht. Je nach Detektionsergebnis und konkreter Ausgestaltung der Detektionsschaltung schließt oder öffnet der entsprechende Schalter.

Die Last des Schalters kann eine Anzeigelampe, ein Relais, einen Eingang einer SPS-Steuerung (SPS: Speicherprogrammierbare Steuerung) oder einen anderen geeigneten elektrischen Verbraucher umfassen.

Erfindungsgemäß ist der Signalbegrenzer dazu eingerichtet, ein am Detektionsknoten anliegendes Signal auf eine einstellbare Signalamplitude zu begrenzen.

Vorteilhafterweise lässt sich mit Hilfe der einstellbaren Signalamplitude die Detektionsschaltung auf bestimmte Einsatzgebiete verbessert einstellen. Sind beispielsweise charakteristische Signalamplituden störender Umgebungssignale in ihrer Größenordnung bekannt oder können eingeschätzt werden, so lässt sich die Schaltung daraufhin einstellen.

Erfindungsgemäßist der Signalbegrenzer dazu eingerichtet, ein am Detektionsknoten anliegendes Signal auf ein einstellbares Messintervall zu begrenzen.

Vorteilhafterweise lässt sich mit einem einstellbaren Messintervall die Detektionsgenauigkeit der Detektionsschaltung weiter verbessern. Treten beispielsweise Störsignale auf, die sowohl einem deutlichen Ausschlag in positiver wie in negativer Richtung aufweisen, so lässt sich dies mit Hilfe des Messintervalls in beide Richtungen entsprechend begrenzen.

In einer weiteren Ausführungsform ist der Signalbegrenzer dazu eingerichtet, ein am Detektionsknoten anliegendes Signal symmetrisch zu begrenzen. Bevorzugt umfasst der Signalbegrenzer dazu Emitterfolger oder antiparallel geschaltete Dioden.

Vorteilhafterweise lässt sich durch die symmetrische Begrenzung wiederum eine verbesserte Genauigkeit der Kurzschlussdetektion erreichen. Durch die Begrenzung der Signalbegrenzung auf ein symmetrisches Messintervall, wird die Detektion eines Kurzschlusses am Detektionsknoten weitgehend unabhängig von der am Detektionsknoten anliegenden Signalamplitude. Des Weiteren kann das Filter auf dieses symmetrische Messintervall optimal eingestellt werden. Ein symmetrisches Messintervall lässt sich ohne Beschränkung sowohl für Low Side- wie auch High Side-Schalter jeweils einstellen.

In einer weiteren Ausführungsform ist das Filter als ein Tiefpassfilter ausgeführt.

In einer weiteren Ausführungsform ist der Kurzschlussdetektor als Komparator ausgeführt und am zweiten Detektoreingang ist ein einstellbarer Schwellenwert zuführbar.

Der einstellbare Schwellenwert ist insbesondere an der Detektionsschaltung mit Hinsicht auf eine konkrete Anwendung einstellbar. Bevorzugt wird dabei der Schwellenwert so gewählt, dass er der Mitte des symmetrischen Messintervalls entspricht. Bevorzugt lässt sich das symmetrische Messintervall von einem Benutzer oder werksseitig einstellen. Es ist aber auch denkbar, das Messintervall im Betrieb automatisch anzupassen.

Die Verwendung des Komparators als Kurzschlussdetektor erlaubt eine einfache Implementierung in einem integrierten Schaltkreis. Mit Hilfe des Schwellenwertes ist es weiterhin vorteilhaft möglich, die Detektionsschaltung für ihre entsprechende Anwendung einzustellen. Wird weiterhin der Schwellenwert so gewählt, dass er der Mitte des symmetrischen Mess-intervalls entspricht, so ist dadurch eine weitere Verbesserung der Genauigkeit der Kurzschlussdetektion möglich. Der Schwellenwert ist damit insbesondere sowohl auf den Signalbegrenzer, wie das nachgeschaltete Filter eingestellt.

In einer weiteren Ausführungsform umfasst der Kontrollschaltkreis einen Entpreller, der mit dem Kontrolleingang und mit dem Filter verbunden ist.

Der Entpreller ist dazu eingerichtet, den Schalter in einstellbaren Zeitintervallen zu steuern.

Durch den Entpreller ist es möglich, eine Detektionsmessung eines Kurzschlusses in bestimmten einstellbaren Zeitintervallen zu wiederholen. Liegt beispielsweise nur für kurze Zeit ein Signal am Detektionsknoten an, das einen Kurzschluss anzeigt, so kann nach dem Zeitintervall der Schalter wieder betrieben werden. Liegt auch nach Ablauf dieses Zeitintervalls ein Signal an, das einen Kurzschluss anzeigt, so wird der Schalter wiederum geschaltet. Auf diese Weise lässt sich iterativ die Kurzschlussdetektion wiederholen, bis der Kurzschluss aufgehoben ist. Vorteilhafterweise lassen sich so unnötig lange Abschaltzeiten des Sensors vermeiden.

In einer weiteren Ausführungsform umfasst der Schalter einen Transistor, dessen Lastseite den Detektionsknoten und den Versorgungsknoten für eine Versorgungsspannung verbindet und dessen Steuerseite mit dem Kontrollausgang verbunden ist.

Vorteilhafterweise lässt sich die Detektionsschaltung durch Verwendung von Transistoren in einem integrierten Schaltkreis realisieren. Dabei können sowohl Low Side- wie auch High Side-Schalter Verwendung finden.

In einer weiteren Ausführungsform umfasst der Schalter Bipolar- oder Unipolartransistoren. Des Weiteren sind auch andere schaltbare Halbleiterelemente denkbar, wie beispielsweise SGBTs (Schottky gate bipolar transistors).

Erfindungsgemäß umfasst ein Verfahren zum Betreiben einer Detektionsschaltung ein Erfassen eines Signals an einem Detektiorisknoten. Eine Signalamplitude des Signals wird begrenzt auf ein Messintervall, welches mittels eines Schwellenwertes einstellbar ist, der die Mitte des Messintervalls bestimmt und ein durch das Begrenzen der Signalamplitude erhaltenes Zwischensignal gefiltert. In Abhängigkeit eines Vergleichs des gefilterten Zwischensignals mit einem vorher bestimmten Vergleichssignal wird ein Kurzschluss detektiert, wobei das Vergleichssignal durch den einstellbaren Schwellenwert bestimmt ist. In Abhängigkeit der Detektion des Kurzschlusses wird am Detektionsknoten ein Bezugspotential angelegt.

Vorteilhafterweise lässt sich durch das Begrenzen der Signalamplitude eine verbesserte Genauigkeit einer Kurzschlussdetektion erzielen. Auf diese Weise wird verhindert, dass ungünstige, aber in der Regel ungefährliche Umgebungssignale, etwa durch Pulse oder Signalspitzen, einen Kurzschluss anzeigen, wenn jedoch keiner vorliegt. Solche Pulse oder Signalspitzen können relativ hohe Signalamplituden aufweisen, sodass sich durch die Begrenzung dieser Signalamplituden eine verbesserte Genauigkeit der Kurzschlussdetektion ergibt.

Durch das zusätzliche Filtern des durch das Begrenzen der Signalamplitude erhaltenen Zwischensignals, lässt sich eine weitere Verbesserung erreichen. So lässt sich das Filtern so einstellen, dass sich für charakteristisch auftretende Signalamplituden ein Zwischensignal ergibt, das unter dem vorher bestimmten Vergleichssignal liegt.

Erfindungsgemäß wird die Signalamplitude der Messgröße auf ein einstellbares Messintervall begrenzt.

Mit Hilfe des einstellbaren Messintervalls lässt sich eine weitere Verbesserung der Genauigkeit der Kurzschlussdetektion erzielen. Durch geeignete Wahl des Messintervalls lässt sich die Signalamplitude auf einen charakteristischen Bereich begrenzen. Auf diese Weise kann ein typischerweise auftretender Bereich von Signalamplituden abgeschätzt oder eingestellt werden.

Erfindungsgemäß wird die Signalamplitude symmetrisch begrenzt.

Durch die symmetrische Begrenzung der Signalamplitude wird die Kurzschlussdetektion in ihrer Genauigkeit noch weiter verbessert. Die Detektion wird auf diese Weise weitgehend unabhängig von der Signalamplitude von am Detektionsknoten anliegenden Störsignalen.

In einer weiteren Ausführungsform wird das Detektieren des Kurzschlusses in einstellbaren Zeitintervallen wiederholt.

Mit Hilfe einer iterativen Wiederholung der Kurzschlussdetektion in einstellbaren Zeitintervallen wird eine unnötige Abschaltzeit vermeidet.

Erfindungsgemäß wird das Vergleichssignal durch die Mitte des Messintervalls bestimmt.

Vorteilhafterweise kann durch Wahl oder Vorgabe des Vergleichssignals das Messintervall bestimmt werden oder umgekehrt. Auf diese Weise ist eine Feinjustage des Verfahrens an auftretende Umgebungssignale möglich.

Die Erfindung wird nachfolgend an Ausführungsbeispielen anhand von Figuren näher erläutert. Funktions- beziehungsweise wirkungsgleiche Elemente tragen gleiche Bezugszeichen. Soweit sich Bauelemente in ihrer Funktion entsprechen, wird deren Beschreibung nicht in jeder der folgenden Figuren wiederholt.

Es zeigen:
- Figur 1: eine Detektionsschaltung nach dem vorgeschlagenen Prinzip, und
- Figuren 2A, 2B, 2C: jeweils beispielhafte Signalverläufe in einer Detektionsschaltung nach dem vorgeschlagenen Prinzip.

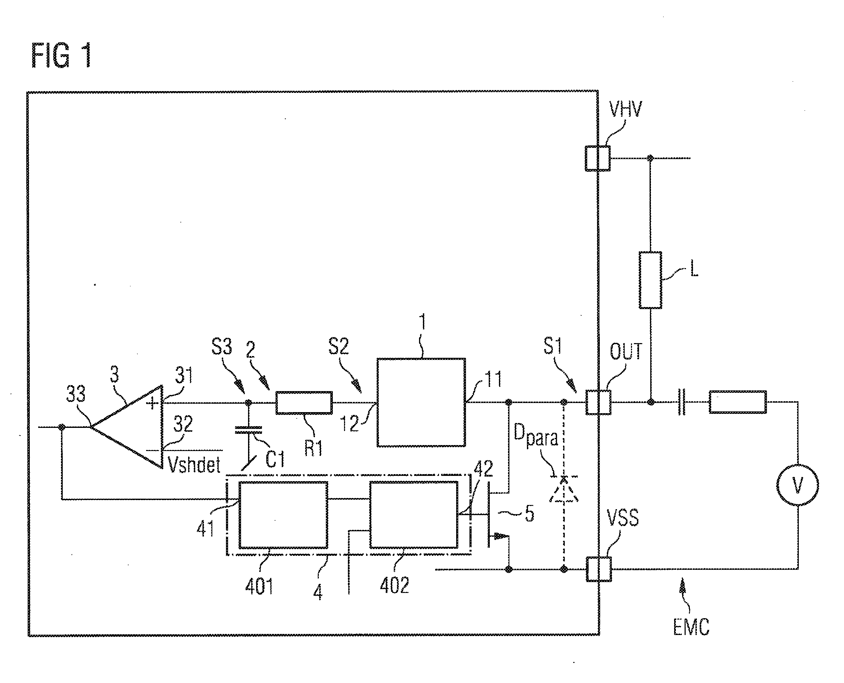

Figur 1 zeigt eine Detektionsschaltung nach dem vorgeschlagenen Prinzip. Die Detektionsschaltung umfasst einen Messpfad, der einen Detektionsknoten OUT, einen Signalbegrenzer 1, ein Filter 2 und einen Kurzschlussdetektor 3 umfasst. Im Einzelnen ist dabei der Detektionsknoten OUT mit einem Signaleingang 11 des Signalbegrenzers 1 verbunden. Ein Signalausgang 12 des Signalbegrenzers 1 ist mit dem Filter 2 gekoppelt. Dabei ist das Filter 2 als RC-Glied ausgestaltet und umfasst einen Widerstand R1 und einen Kondensator C1. Der Widerstand R1 ist sowohl mit dem Signalausgang 12, wie auch mit einem ersten Detektoreingang 31 des Kurzschlussdetektors 3 verbunden. Der Kurzschlussdetektor 3 weist ferner einen zweiten Detektoreingang 32 auf, an dem ein einstellbarer Schwellenwert Vshdet anliegt.

Ein Detektorausgang 33 ist mit einem Steuerungspfad über einen Kontrolleingang 41 verbunden. Der Steuerungspfad umfasst einen Kontrollschaltkreis 4 zum Steuern eines Schalters 5, der zum einen den Kontrolleingang 41 aufweist und zum anderen einen Entpreller 401 und eine Schaltvorrichtung 402 umfasst. Der Entpreller 401 liegt am Kontrolleingang 41 an und ist mit der Schaltvorrichtung 402 gekoppelt. Ein Kontrollausgang 42 verbindet die Schaltvorrichtung 402 mit dem Schalter 5. Der Schalter 5 ist wiederum mit dem Detektionsknoten OUT und einem Versorgungsknoten VSS gekoppelt.

Zum Zwecke einer vereinfachten Erläuterung ist an der Detektionsschaltung über den Detektionsknoten OUT und eine Spannungsversorgung VHV eine Last L angeschlossen. Die angeschlossene Last L stellt beispielsweise ein Relais, eine Lampe oder einen Schalteingang einer SPS-Steuerung dar. Zudem ist ein EMC-Generator EMC über den Detektionsknoten OUT und die Versorgungsspannung VSS an die Detektionsschaltung gekoppelt.

Die Detektionsschaltung detektiert nun am Detektionsknoten anliegende Signale und weist Mittel auf Signale dahingehend voneinander zu unterscheiden, ob sie einen Kurzschluss anzeigen oder nicht. Die am Detektionsknoten anliegenden Signale umfassen Sensorsignale (beziehungsweise Kurzschlusssignale) und durch den EMC-Generator EMC generierte EMC-Signale. Dabei ist der EMC-Generator im normalen Anwendungsfall beispielsweise ein parallel verlegtes Kabel oder andere elektrische Größen in der unmittelbaren Umgebung der Schaltung.

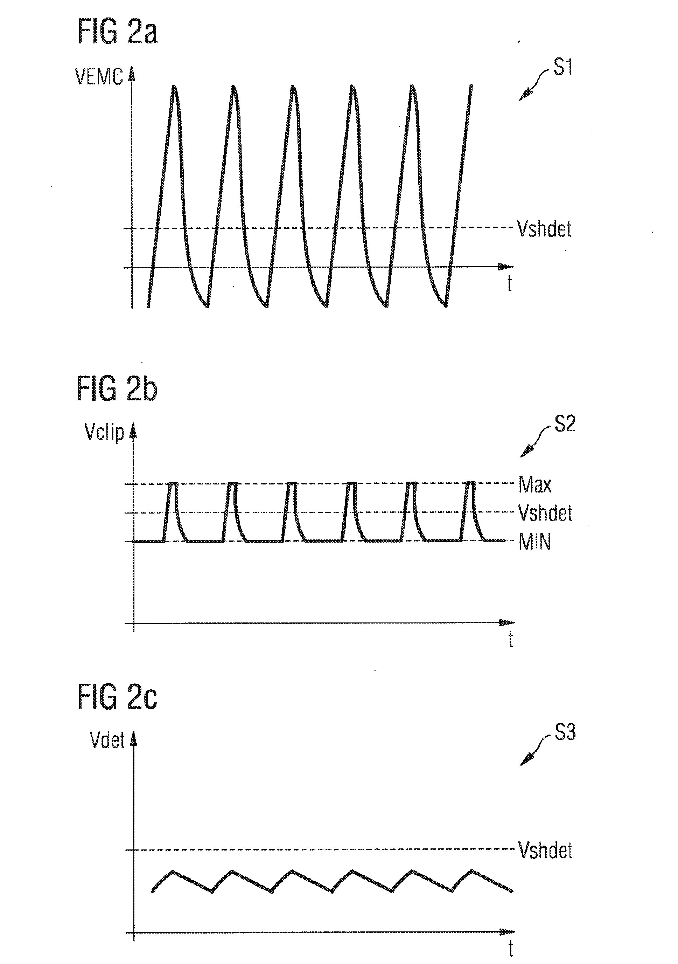

Im Allgemeinen liegt somit am Detektionsknoten OUT ein Signal VEMC an. Die charakteristischen Signalverläufe, die an unterschiedlichen Punkten S1, S2, S3 der Detektionsschaltung auftreten, werden mit Bezug auf die Figuren 2A, 2B und 2C näher beschrieben.

Zunächst wird das Signal VEMC, das am Detektionsknoten OUT anliegt, dem Signalbegrenzer 1 übergeben. In diesem Signalbegrenzer 1 wird die Signalamplitude des Signals VEMC symmetrisch begrenzt. Die Begrenzung erfolgt dabei innerhalb eines Messintervalls, das durch eine untere Intervallgrenze MIN und eine obere Intervallgrenze MAX definiert ist. Ein auf diese Weise begrenztes Zwischensignal wird vom Signalbegrenzer 1 an ein Filter 2 übergeben. Dieses ist bevorzugt ein Tiefpassfilter, bestehend aus dem Widerstand R1 und dem Kondensator C1. Auf diese Weise wird ein gefiltertes Zwischensignal generiert, das in der Folge am ersten Detektionseingang 31 anliegt. Der Kurzschlussdetektor 3 ist beispielsweise als ein Komparator ausgeführt, an dessen zweiten Eingang 32 der einstellbare Schwellenwert Vshdet anliegt. Bevorzugt wird dabei der Schwellenwert Vshdet so gewählt, dass er der Mitte des Messintervalls MIN, MAX entspricht. Auf diese Weise wird sichergestellt, dass das gefilterte Zwischensignal Vdet in der Regel unterhalb des Schwellenwertes Vshdet bleibt. Für unterschiedliche Signalamplituden von am Detektionsknoten OUT anliegenden Störsignalen wird somit kein Kurzschlussdetektionsereignis ausgelöst.

Zeigt jedoch der Kurzschlussdetektor einen Kurzschluss an, so generiert er ein Kontrollsignal, das dem Steuerungspfad über den Kontrolleingang 41 übergeben wird. Der Kontrollschaltkreis 4 steuert dabei den Schalter 5. Dazu sind am optionalen Entpreller 401 Zeitintervalle t einstellbar. Das Kontrollsignal veranlasst die Schaltervorrichtung 402 den Schalter 5 (beispielsweise ein NMOS-Transistor (NMOS: n-type metal-oxide semiconductor) oder andere geeignete Transistoren zu schalten. Im Falle eines Kurzschlusses wird der Schalter 5 geöffnet (beispielsweise der NMOS-Transistor ausgeschaltet).

Der (optionale) Entpreller 401 hat die Aufgabe, den Schalter 5 zu öffnen, wenn ein von der Detektionsschaltung detektierter Kurzschluss für eine gewisse Zeit tb (beispielsweise tb = 100 µs) angezeigt wird. Sobald am Entpreller 401 während der gesamten Zeit tb ein Kurzschluss angezeigt wird, so wird dies der Schaltvorrichtung 402 signalisiert. Diese wiederum schaltet den Schalter 5 für das einstellbare Zeitintervall t von beispielsweise 100 ms. Das einstellbare Zeitintervall t lässt sich dabei geeignet programmieren. In gewissem Sinne ist der Entpreller 401 somit ein zusätzliches Tiefpassfilter, welches aber digital realisiert ist.

Vorteilhafterweise erlaubt der Messpfad eine erhöhte Genauigkeit der Kurzschlussdetektion. Durch das am Signalbegrenzer 1 einstellbare symmetrische Messintervall MIN, MAX wird die Kurzschlussdetektion in weiten Bereichen unabhängig von einer Signalamplitude der am Detektionsknoten OUT anliegenden Spannung VEMC. Diese ist beispielsweise durch einen parasitären Diodeneffekt DPARA durch den Schalter 5 stark asymmetrisch.

Auch asymmetrische Signale am Detektionsknoten OUT lassen sich mit hoher Genauigkeit berücksichtigen. Des Weiteren wird die Genauigkeit einer Kurzschlussdetektion durch das Tiefpassfilter 2 und den Vergleich mit dem Schwellenwert Vshdet weiter verbessert. Der optionale Entpreller 401 hat des Weiteren den vorteilhaften Effekt, dass nach Detektion eines Kurzschlusses die Abschaltzeiten einer angeschlossenen Last gering gehalten werden können.

Der Schalter 5 kann ohne Beschränkung der Erfindung wie in Figur 1 gezeigt als ein Low-Side-, oder alternativ als ein High-Side-Schalter ausgeführt sein. Die vorgestellten Prinzipien der Detektionsschaltung lassen sich entsprechend abändern und auf den jeweiligen Schaltertyp anwenden. Entsprechend lässt sich der Schalter 5 je nach Typ mittels der Spannungsversorgung VHV oder der Versorgungsspannung VSS betreiben.

Die Figuren 2A, 2B und 2C zeigen die Signalverläufe an den in der Figur 1 markierten Stellen S1, S2 und S3. Aufgetragen ist jeweils das auftretende Signal VEMC, Vclip, Vdet gegen die Zeit t.

Im Einzelnen zeigt die Figur 2A das Signal VEMC, das am Detektionsknoten OUT anliegt. In der Figur 1 ist dieser Punkt mit S1 bezeichnet. Beispielsweise durch eine parasitäre Diode DPARA des verwendeten Schalters 5 zeigt das anliegende Signal VEMC einen stark asymmetrischen Signalverlauf. Dieser kann jedoch auch durch die Quelle des Störsignals VEMC selbst ausgelöst sein. Wie in der Figur 2A ersichtlich, liegt das Signal VEMC im Mittel über dem Schwellenwert Vshdet und würde am Kurzschlussdetektor 3 ohne weitere Maßnahmen einen Kurzschluss anzeigen.

Figur 2B zeigt den Signalverlauf an der Stelle S2 der Figur 1 und zeigt das begrenzte Zwischensignal Vclip an, nachdem die Signalamplitude des Signals VEMC durch den Signalbegrenzer 1 begrenzt wurde. Durch das symmetrische Messintervall MIN, MAX ist dieser Signalamplitude des begrenzten Zwischensignals Vclip entsprechend begrenzt und liegt im Mittel auf dem Schwellenwert Vshdet oder darunter.

Figur 2C zeigt das gefilterte Zwischensignal Vdet aufgetragen gegen die Zeit T an der Stelle S3 der Figur 1. Durch die Filterung wird erreicht, dass auch bei stark unterschiedlichen und auch asymmetrischen Signalamplituden Störsignale in Folge von EMC-Konditionen unter dem Schwellenwert Vshdet verbleiben. Diese lassen sich daraufhin eindeutig von Kurzschlussdetektionssignalen unterscheiden. Ein solches Kurzschlusssignal würde beispielsweise über dem Schwellenwert Vshdet liegen und auch zeitlich kaum schwanken solange der Kurzschluss vorliegt.

### Bezugszeichenliste

- 1: Signalbegrenzer
- 11: Signaleingang
- 12: Signalausgang
- 2: Filter
- 3: Kurzschlussdetektor
- 31: erster Detektoreingang
- 32: zweiter Detektoreingang
- 33: Detektorausgang
- 4: Kontrollschaltkreis
- 41: Kontrolleingang
- 42: Kontrollausgang
- 401: Entpreller
- 402: Schaltvorrichtung
- 5: Schalter
- C1: Kondensator
- DPARA: parasitäre Diode
- EMC: EMC-Generator
- L: Last
- MIN: Messintervallgrenze
- MAX: Messintervallgrenze
- OUT: Detektionsknoten
- S1: Signalpunkt
- S2: Signalpunkt
- S3: Signalpunkt
- t: einstellbares Zeitintervall
- tb: Zeit
- Vclip: begrenztes Zwischensignal
- Vdet: gefiltertes Zwischensignal
- VEMC: Signal am Detektionsknoten
- VHV: Versorgungsspannung
- Vshdet: Schwellenwert
- VSS: Versorgungsspannung

## Patentansprüche

1. Detektionsschaltung mit
- einem Detektionspfad, umfassend:
- einen Signalbegrenzer (1) zum Begrenzen der Signalamplitude eines Signals auf ein Messintervall (MIN, MAX), welches mittels eines Schwellenwertes einstellbar ist, wobei der Schwellenwert die Mitte des Messintervalls (MIN, MAX) bestimmt und der Signalbegrenzer (1) mittels eines Signaleingangs (11) mit einem Detektionsknoten (OUT) verbunden ist,
- ein Filter (2), das mit einem Signalausgang (12) des Signalbegrenzers (1) gekoppelt ist, und
- einen Kurzschluss-Detektor (3) mit einem ersten und zweiten Detektoreingang (31, 32), sowie einem Detektorausgang (33), wobei der erste Detektoreingang (31) mit dem Filter (2) gekoppelt ist, und mit
- einem Steuerungspfad, umfassend:
- einen Kontrollschaltkreis (4) zum Steuern eines Schalters (5), der mittels eines Kontrolleingangs (41) mit dem Detektorausgang (33) gekoppelt und mittels eines Kontrollausgangs (42) mit dem Schalter (5) verbunden ist, und
- den Schalter (5), der mit dem Detektionsknoten (OUT) und einem Versorgungsknoten (VSS) gekoppelt ist.

2. Detektionsschaltung nach Anspruch 1, wobei das Filter (2) als ein Tiefpassfilter ausgeführt ist.

3. Detektionsschaltung nach Anspruch 1 oder 2, wobei der Kurzschluss-Detektor (3)
- als Komparator ausgeführt ist, und
- am zweiten Detektoreingang (32) der einstellbare Schwellenwert (Vshdet) zuführbar ist.

4. Detektionsschaltung nach einem der Ansprüche 1 bis 3, wobei
- der Kontrollschaltkreis (4) einen Entpreller (401) umfasst, der mit dem Kontrolleingang (41) und mit dem Filter (2) verbunden ist, und
- der Entpreller (401) dazu eingerichtet ist, den Schalter (5) in einstellbaren Zeitintervallen zu steuern.

5. Detektionsschaltung nach einem der Ansprüche 1 bis 4, wobei der Schalter (5) einen Transistor umfasst,
- dessen Lastseite den Detektionsknoten (OUT) und den Versorgungsknoten (VSS) für eine Versorgungsspannung verbindet, und
- dessen Steuerseite mit dem Kontrollausgang (42) verbunden ist.

6. Detektionsschaltung nach einem der Ansprüche 1 bis 5, wobei der Schalter (5) einen Bipolar- oder Unipolar-Transistor oder andere schaltbare Halbleiterelemente umfasst.

7. Verfahren zum Betreiben einer Detektionsschaltung, umfassend:
- Erfassen eines Signals (EMC) an einem Detektionsknoten (OUT),
- Begrenzen der Signalamplitude des Signals (EMC) auf ein Messintervall (MIN, MAX), welches mittels eines Schwellenwertes einstellbar ist, der die Mitte des Messintervalls (MIN, MAX) bestimmt,
- Filtern eines durch das Begrenzen der Signalamplitude erhaltenen Zwischensignals (Vclip),
- Detektieren eines Kurzschlusses in Abhängigkeit eines Vergleichs des gefilterten Zwischensignals (Vdet) mit einem vorher bestimmten Vergleichssignal (Vshdet), welches durch den einstellbaren Schwellenwert bestimmt ist und
- Anlegen eines Bezugspotentials (VSS) am Detektionsknoten (OUT) in Abhängigkeit der Detektion des Kurzschlusses.

8. Verfahren nach Anspruch 7, bei dem das Detektieren des Kurzschlusses in einstellbaren Zeitintervallen wiederholt wird.

## Claims

1. A detection circuit, comprising
- a detection path, including:
- a signal limiter (1) for limiting the signal amplitude of a signal to a measuring interval (MIN, MAX) which can be adjusted by means of a threshold value, the threshold value determining the center of the measuring interval (MIN, MAX) and the signal limiter (1) being connected to a detection node (OUT) by means of a signal input (11),
- a filter (2) coupled to a signal output (12) of the signal limiter (1), and
- a short-circuit detector (3) comprising first and second detector inputs (31, 32) as well as a detector output (33), the first detector input (31) being coupled to the filter (2), and comprising
- a control path, including:
- a control circuitry (4) for controlling a switch (5), which is connected to the detector output (33) by means of a control input (41) and is connected to the switch (5) by means of a control output (42), and
- the switch (5) which is coupled to the detection node (OUT) and to a supply node (VSS).

2. The detection circuit according to claim 1, wherein the filter (2) is implemented as a low-pass filter.

3. The detection circuit according to claim 1 or 2, wherein the short-circuit detector (3)
- is implemented as a comparator, and
- the adjustable threshold value (Vshdet) can be fed to the second detector input (32).

4. The detection circuit according to any of the claims 1 to 3, wherein
- the control circuitry (4) comprises a debouncing means (401) connected to the control input (41) and to the filter (2), and
- the debouncing means (401) is arranged for controlling the switch (5) in adjustable time intervals.

5. The detection circuit according to any of the claims 1 to 4, wherein the switch (5) comprises a transistor,
- whose load side connects the detection node (OUT) and the supply node (VSS) for a supply voltage, and
- whose control side is connected to the control output (42).

6. The detection circuit according to any of the claims 1 to 5, wherein the switch (5) comprises a bipolar or unipolar transistor or any other switchable semiconductor elements.

7. A method of operating a detection circuit, comprising:
- detecting a signal (EMC) on a detection node (OUT),
- limiting the signal amplitude of the signal (EMC) to a measuring interval (MIN, MAX) which can be adjusted by means of a threshold value determining the center of the measuring interval (MIN, MAX),
- filtering an intermediate signal (Vclip) obtained by the limiting of the signal amplitude,
- detecting a short-circuit depending on a comparison of the filtered intermediate signal (Vdet) with a comparative signal (Vshdet) which has been defined in advance and is determined by the adjustable threshold value and
- applying a reference potential (VSS) to the detection node (OUT) depending on the detection of the short-circuit.

8. The method according to claim 7, wherein the detection of the short-circuit is repeated in adjustable time intervals.

## Revendications

1. Circuit de détection comportant
- une voie de détection, comprenant:
- un limiteur de signal (1) destiné à limiter l'amplitude d'un signal à un intervalle de mesure (MIN, MAX), lequel est réglable moyennant une valeur seuil, la valeur seuil déterminant le milieu de l'intervalle de mesure (MIN, MAX) et le limiteur de signal (1) étant relié à un noeud de détection (OUT) moyennant une entrée de signal (11),
- un filtre (2) qui est couplé à une sortie de signal (12) du limiteur de signal (1), et
- un détecteur de court-circuit (3) pourvu d'une première et d'une deuxième entrée de détecteur (31, 32), ainsi que d'une sortie de détecteur (33), la première entrée de détecteur (31) étant couplée au filtre (2), et comportant
- une voie de commande, comprenant:
- un circuit de commutation de contrôle (4) destiné à commander un commutateur (5), et qui est couplé à la sortie de détecteur (33) moyennant une entrée de contrôle (41) et relié au commutateur (5) moyennant une sortie de contrôle (42), et
- le commutateur (5), qui est couplé au noeud de détection (OUT) et à un noeud d'alimentation (VSS).

2. Circuit de détection selon la revendication 1, dans lequel le filtre (2) est exécuté comme filtre passe-bas.

3. Circuit de détection selon la revendication 1 ou 2, dans lequel le détecteur de court-circuit (3)
- est exécuté comme comparateur, et
- la valeur seuil réglable (Vshdet) peut être amenée au niveau de la deuxième entrée de détecteur (32).

4. Circuit de détection selon l'une des revendications 1 à 3, dans lequel
- le circuit de commutation de contrôle (4) comporte un dispositif anti-rebond (401) qui est relié à l'entrée de contrôle (41) et au filtre (2), et
- le dispositif anti-rebond (401) est configuré pour commander le commutateur (5) à intervalles de temps réglables.

5. Circuit de détection selon l'une des revendications 1 à 4, dans lequel le commutateur (5) comporte un transistor
- dont le côté charge relie le noeud de détection (OUT) et le noeud d'alimentation (VSS) pour une tension d'alimentation, et
- dont le côté commande est relié à la sortie de contrôle (42).

6. Circuit de détection selon l'une des revendications 1 à 5, dans lequel le commutateur (5) comprend un transistor bipolaire ou unipolaire ou d'autres éléments semiconducteurs commutables.

7. Procédé pour faire fonctionner un circuit de détection, comportant:
- l'acquisition d'un signal (EMC) au niveau d'un noeud de détection (OUT),
- la limitation de l'amplitude du signal (EMC) à un intervalle de mesure (MIN, MAX), lequel est réglable moyennant une valeur seuil qui détermine le milieu de l'intervalle de mesure (MIN, MAX),
- le filtrage d'un signal intermédiaire (Vclip) reçu suite à la limitation de l'amplitude de signal,
- la détection d'un court-circuit en fonction d'une comparaison du signal intermédiaire filtré (Vdet) avec un signal de comparaison (Vshdet) déterminé précédemment, lequel est déterminé par la valeur seuil réglable, et
- l'application d'un potentiel de référence (VSS) au niveau du noeud de détection (OUT) en fonction de la détection du court-circuit.

8. Procédé selon la revendication 7, dans lequel la détection du court-circuit se répète à intervalles de temps réglables.
